(19) Europäisches Patentamt

European Patent Office

Office européen des brevets

(11) Veröffentlichungsnummer: **0 658 927 A1**

## (12) EUROPÄISCHE PATENTANMELDUNG

(21) Anmeldenummer: **94116892.4**

(22) Anmeldetag: **26.10.94**

(51) Int. Cl.⁶: **H01L 21/306**, H01L 21/308

(30) Priorität: **15.12.93 DE 4342767**

(43) Veröffentlichungstag der Anmeldung:
**21.06.95 Patentblatt 95/25**

(84) Benannte Vertragsstaaten:
**DE ES FR GB IT NL**

(71) Anmelder: **ANT Nachrichtentechnik GmbH
Gerberstrasse 33
D-71522 Backnang (DE)**

(72) Erfinder: **Kuke, Albrecht, Dr.
Nelkenweg 2
D-71549 Auenwald (DE)**

(54) Verfahren zur Herstellung einer quaderförmigen Vertiefung zur Aufnahme eines Bauelementes in einer Trägerplatte.

㊵ Bei einem Verfahren zur Herstellung einer quaderförmigen Vertiefung zur Aufnahme eines Bauelementes in einer Trägerplatte wird auf einer Siliziumscheibe (1), deren Oberfläche in der (100)-Ebene liegt, eine Maske mit mindestens einem rechteckigen Fenster (3, 3') angeordnet, wobei die Seiten des Fensters (3, 3') parallel zu <100>-Richtungen ausgerichtet werden und die Seitenlängen um einen vorgegebenen Wert kleiner als die vorgesehenen Kantenlängen der Vertiefung (2, 2') sind. Es erfolgt eine anisotrope Ätzung, bis die Kanten der Vertiefung (2, 2') die vorgegebene Länge erreichen.

Fig. 1

Die Erfindung betrifft ein Verfahren zur Herstellung einer quaderförmigen Vertiefung zur Aufnahme eines Bauelementes in einer Trägerplatte.

Zur Verringerung der Montagekosten, zur Erhöhung der Zuverlässigkeit sowie zur Verringerung der Leitungsinduktivitäten werden bei der sogenannten Multi-Chip-Modul-Technik (MCM) mehrere ungehäuste Halbleiter-Bauelemente gemeinsam auf einen Träger montiert. Dabei ist eine elektrische Verbindung der Bauelemente oberhalb der Ebene der Bauelementen-Oberflächen durch elektrische Leiterbahnen vorteilhaft. Hierzu ist es erforderlich, entweder den Raum zwischen den Bauelementen mit Isoliermaterial bis zur Höhe der Bauelementen-Oberfläche aufzufüllen oder die Bauelemente in Vertiefungen der Trägerplatte soweit zu versenken, daß ihre Oberflächen genau in der Ebene der Trägerplatte zu liegen kommen. Dann läßt sich in dieser Ebene eine Schicht aus Isoliermaterial, beispielsweise Polyimid, aufbringen, welche die Leiterbahnen trägt, wobei die Fläche der darunterliegenden Bauelemente mitverwendet werden kann.

Aufgabe der vorliegenden Erfindung ist es, quaderförmige Vertiefungen zur Aufnahme von Bauelementen in Trägerplatten herzustellen, die bezüglich ihrer lateralen und vertikalen Dimension exakt an die aufzunehmenden Bauelemente angepaßt sind.

Diese Aufgabe wird erfindungsgemäß dadurch gelöst, daß auf einer Siliziumscheibe, deren Oberfläche in der (100)-Ebene liegt, eine Maske mit mindestens einem rechteckigen Fenster angeordnet wird, wobei die Seiten des Fensters parallel zu <100>-Richtungen ausgerichtet werden und die Seitenlängen um einen vorgegebenen Wert kleiner als die vorgesehenen Kantenlängen der Vertiefung sind, und daß eine anisotrope Ätzung erfolgt, bis die Kanten der Vertiefung die vorgegebene Länge erreichen. Vorzugsweise ist bei dem erfindungsgemäßen Verfahren vorgesehen, daß der vorgegebene Wert dem Doppelten der vorgesehenen Tiefe der Vertiefung entspricht.

Ein Vorteil des erfindungsgemäßen Verfahrens besteht darin, daß die vorgesehenen Maße der Vertiefung sehr genau erreicht werden können. Ferner sind die Wände der Vertiefung senkrecht, so daß zwischen dem Bauelement und der Wand der Vertiefung kein prismatischer Spalt verbleibt, der die Aufbringung einer Trägerschicht für die Leiterbahnen erschwert oder gar unmöglich macht.

Schließlich zeichnet sich die Trägerplatte aus Silizium durch eine hohe Ebenheit, eine Preiswürdigkeit und dadurch aus, daß sie im übrigen mit Mitteln der integrierten Schaltungstechnik bearbeitet werden kann.

Bei den üblicherweise zur Herstellung von integrierten Schaltungen verwendeten Siliziumscheiben liegt deren Oberfläche bereits in der (100)-Ebene.

Gemäß einer vorteilhaften Ausführungsform der Erfindung ist dann vorgesehen, daß zwei Seiten des Fensters einen Winkel von 45° mit einer Abflachung der Siliziumscheibe bilden, dem sogenannten Flat, der die <110>-Richtungen kennzeichnet.

Ausführungsbeispiele der Erfindung sind in der Zeichnung anhand mehrerer Figuren dargestellt und in der nachfolgenden Beschreibung näher erläutert. Es zeigt:

Fig. 1 eine schematische Darstellung einer Siliziumscheibe mit Masken-Fenstern und Vertiefungen und

Fig. 2 einen Schnitt durch einen Teil der Siliziumscheibe mit einer erfindungsgemäß hergestellten Vertiefung und einem Bauelement, das mit Leiterbahnen verbunden ist, die über der Trägerplatte und über dem Bauelement liegen.

Bei dem erfindungsgemäßen Verfahren wird von einer Siliziumscheibe (Wafer) ausgegangen, deren Oberfläche in der (100)-Ebene liegt. Das Fenster der Maske zur Erzeugung der Vertiefung wird jedoch nicht, wie sonst üblich, mit den Rändern parallel zu der <110>-Richtung ausgerichtet, die üblicherweise durch eine Abflachung (Flat) am Rand des Wafers gekennzeichnet ist, sondern unter 45° zu dieser gekennzeichneten Richtung. Dieses ist eine <100>-Richtung. Im Unterschied zur anisotropen Ätzung mit Masken, deren Fensterränder parallel zur <110>-Richtung ausgerichtet sind, erhält man hierbei keine Selbststoppung des Ätzvorganges beim Erreichen einer schwer ätzenden (111)-Ebene. Der Ätzprozeß läuft vielmehr unbegrenzt weiter.

Die anisotrope Ätzung des Siliziums beruht auf der Abhängigkeit der Ätzgeschwindigkeit von der kristallografischen Richtung. In <111>-Richtung ist die Ätzgeschwindigkeit etwa um den Faktor 100 geringer als in der <133>-Richtung, in der die maximale Ätzgeschwindigkeit erreicht wird. Daneben gibt es aber noch ein Nebenminimum in der Ätzgeschwindigkeit, das in der <100>-Richtung liegt. Dieses <100>-Nebenminimum ist aber bei weitem nicht so ausgeprägt wie das Hauptminimum in <111>-Richtung. Die Ätzgeschwindigkeit verringert sich in <100>-Richtung nur auf etwa 75% ihres Maximalwertes in <133>-Richtung. Obwohl der Ätzprozeß an einer (100)-Ebene nicht zum Stehen kommt, führt doch die Verringerung der Ätzgeschwindigkeit im Nebenminimum dazu, daß während des Ätzprozesses alle (100)-Ebenen als sehr glatte Flächen herausgebildet werden. Dabei werden die Seitenwände gegenüber den Maskenrändern um den gleichen Betrag zurückversetzt, wie die Ätzung in die Tiefe fortschreitet. Diese Erkenntnis liegt der Erfindung zugrunde.

Sind $1_m$ und $b_m$ die Länge und Breite des Maskenfensters auf der Waferoberfläche, so erhält man eine quaderförmige Vertiefung der Länge 1, Breite b und Tiefe t mit

$$1 = 1_m + 2 {*} t \quad (1)$$

$$b = b_m + 2 {*} t \quad (2)$$

Die Tiefe t, die gleich der Unterätzung ist, ergibt sich aus der Ätzdauer d und der Ätzgeschwindigkeit v zu

$$t = v {*} d \quad (3)$$

Durch Vorgabe der Größe der Vertiefung 1, b und t bei bekannter Ätzgeschwindigkeit läßt sich die benötigte Größe des Maskenfensters bestimmen.

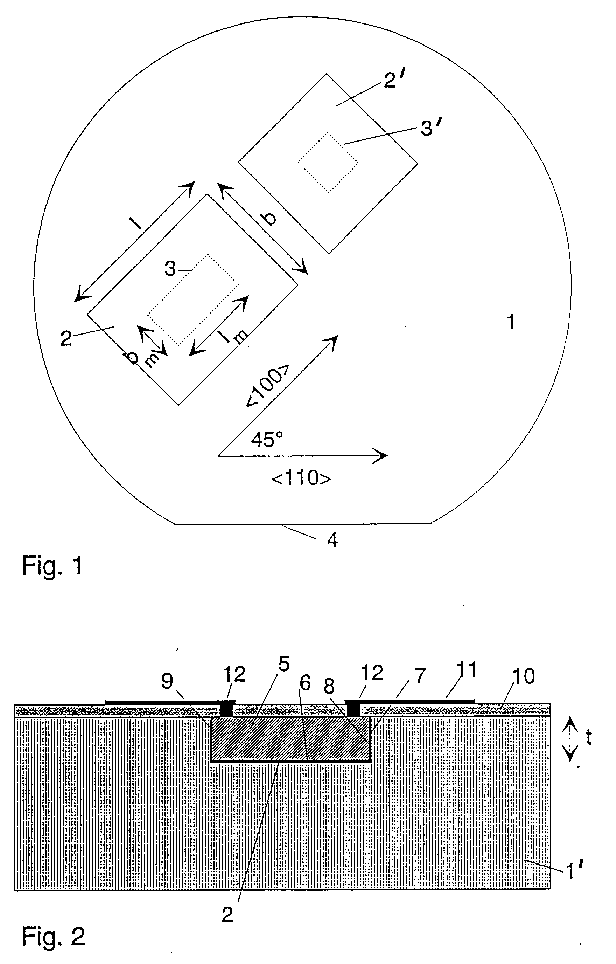

Der in Fig. 1 dargestellte Wafer 1 aus Silizium soll mit Hilfe des erfindungsgemäßen Verfahrens mit Vertiefungen 2, 2' versehen werden. Dazu wird zunächst die Maske mit den gestrichelt dargestellten rechteckigen Fenstern 3, 3' aufgebracht. Das Fenster 3 hat beispielsweise die Abmessungen $1_m$ und $b_m$. Dadurch, daß die Ätzung nicht nur senkrecht zur Oberfläche des Wafers 1, sondern auch parallel dazu fortschreitet, ergeben sich dann die Abmessungen 1 und b für die Vertiefung 2. Der zu Zwecken der Ausrichtung an jedem Wafer vorgesehene Flat 4 befindet sich in der <100>-Richtung, welche zur <110>-Richtung und damit zur Richtung der jeweiligen Kanten der Vertiefungen 2, 2' einen Winkel von 45° bildet.

Bei dem in Fig. 2 dargestellten fertig montierten Ausführungsbeispiel ist in dem aus dem Wafer 1 (Fig. 1) hergestellten Träger 1' die Vertiefung 2 mit der Tiefe t eingeätzt. In diese Vertiefung ist ein Bauelement (Halbleiter-Chip) 5 eingesetzt und am Boden 6 der Vertiefung auf bekannte Weise durch Löten oder Kleben befestigt. Die Seitenwände 7 der Vertiefung 2 bilden mit den Seitenwänden 8 des Bauelementes 5 einen sehr schmalen und parallelen Spalt, der vorzugsweise mit einem wärmeleitenden Kleber ausgefüllt sein kann. Auf die Oberfläche des Trägers 1' und des Bauelementes 5 wird eine isolierende Trägerschicht 10 aufgebracht, die die Leiterbahnen 11 trägt. Diese sind über Durchkontaktierungen 12 mit den Anschlußflächen des Bauelementes 5 verbunden.

**Patentansprüche**

1. Verfahren zur Herstellung einer quaderförmigen Vertiefung zur Aufnahme eines Bauelementes in einer Trägerplatte, dadurch gekennzeichnet, daß auf einer Siliziumscheibe (1), deren Oberfläche in der (100)-Ebene liegt, eine Maske mit mindestens einem rechteckigen Fenster (3, 3') angeordnet wird, wobei die Seiten des Fensters parallel zu <100>-Richtungen ausgerichtet werden und die Seitenlängen um einen vorgegebenen Wert kleiner als die vorgesehenen Kantenlängen der Vertiefung (2, 2') sind, und daß eine anisotrope Ätzung erfolgt, bis die Kanten der Vertiefung (2, 2') die vorgegebene Länge erreichen.

2. Verfahren nach Anspruch 1, dadurch gekennzeichnet, daß der vorgegebene Wert dem Doppelten der vorgesehenen Tiefe der Vertiefung entspricht.

3. Verfahren nach einem der vorhergehenden Ansprüche, dadurch gekennzeichnet, daß zwei Seiten des Fensters einen Winkel von 45° mit einer Abflachung der Siliziumscheibe bilden.

2′

3′

l

b

3

2

b_m

l_m

1

<100>

45°

<110>

4

Fig. 1

9    12    5    6  8    12    7    11    10

t

1′

2

Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | DE-A-28 45 062 (HITACHI LTD)<br>* Seite 12, Zeile 22 - Seite 13, Zeile 27 *<br>* Seite 21, Zeile 1 - Zeile 19;<br>Abbildungen 9A,9B *<br>* Seite 22, Zeile 33 - Seite 24, Zeile 5;<br>Abbildungen 10,11A-11C *<br>--- | 1-3 | H01L21/306<br>H01L21/308 |
| X | US-A-4 969 359 (MATI MIKKOR)<br>* Spalte 5, Zeile 19 - Zeile 24 *<br>* Spalte 5, Zeile 50 - Spalte 6, Zeile 37;<br>Abbildungen 1-4B *<br>--- | 1,2 | |
| A | US-A-4 866 501 (DANIEL J. SHANEFIELD)<br>* Spalte 1, Zeile 31 - Zeile 43 *<br>* Spalte 1, Zeile 51 - Zeile 66; Abbildung 1 *<br>--- | 1 | |
| A | PROCEEDINGS IEEE MICRO ELECTRO MECHANICAL SYSTEMS, 30. Januar 1991, NARA, JAPAN<br>Seiten 216 - 220<br>AKIRA KOIDE ET AL. 'Simulation of two-dimensional etch profile of silicon during orientation-dependent anisotropic etching'<br>* Seite 219, Absatz 4.1; Abbildung 6; Tabelle 2 *<br>* Seite 22, Absatz 5 *<br>--- | 1-3 | **RECHERCHIERTE SACHGEBIETE (Int.Cl.6)**<br><br>H01L<br>H05K |
| A | PATENT ABSTRACTS OF JAPAN<br>vol. 8, no. 88 (E-240) 21. April 1984<br>& JP-A-59 008 375 (MATSUSHITA DENSHI KOGYO K.K.) 17. Januar 1984<br>* Zusammenfassung *<br>---<br><br>-/-- | 1,3 | |

Der vorliegende Recherchenbericht wurde für alle Patentansprüche erstellt

| Recherchenort | Abschlußdatum der Recherche | Prüfer |
|---|---|---|
| BERLIN | 7. April 1995 | Klopfenstein, P |

Europäisches Patentamt

**EUROPÄISCHER RECHERCHENBERICHT**

Nummer der Anmeldung

EP 94 11 6892

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | PATENT ABSTRACTS OF JAPAN<br>vol. 17, no. 683 (E-1477) 15. Dezember 1993<br>& JP-A-05 234 901 (KOMATSU LTD.) 10. September 1993<br>* Zusammenfassung *<br>--- | 1 | |
| A | EP-A-0 288 052 (SUMITOMO ELECTRIC IND. LTD.)<br>* Spalte 4, Zeile 37 - Spalte 5, Zeile 48; Abbildungen 2A-2E *<br>--- | 1 | |
| A | US-A-5 063 177 (BERNARD D. GELLER ET AL.)<br>* Spalte 2, Zeile 16 - Zeile 31 *<br>* Spalte 3, Zeile 17 - Zeile 32; Abbildung 1 *<br>* Spalte 4, Zeile 40 - Zeile 65 *<br>----- | 1 | |
| | | | **RECHERCHIERTE SACHGEBIETE (Int.Cl.6)** |

Der vorliegende Recherchenbericht wurde für alle Patentansprüche erstellt

| Recherchenort | Abschlußdatum der Recherche | Prüfer |
|---|---|---|
| BERLIN | 7. April 1995 | Klopfenstein, P |